Europäisches Patentamt

European Patent Office

Office européen des brevets

(19)

(11) **EP 1 364 984 A1**

(12) **EUROPEAN PATENT APPLICATION**
published in accordance with Art. 158(3) EPC

(43) Date of publication:
**26.11.2003 Bulletin 2003/48**

(51) Int Cl.[7]: **C08J 7/06**, C08J 7/00

(21) Application number: **01999601.6**

(22) Date of filing: **05.12.2001**

(86) International application number:
**PCT/JP01/10645**

(87) International publication number:
**WO 02/046281 (13.06.2002 Gazette 2002/24)**

(84) Designated Contracting States:
**AT BE CH CY DE DK ES FI FR GB GR IE IT LI LU MC NL PT SE TR**

(30) Priority: **05.12.2000 JP 2000370377**

(71) Applicant: **Learonal Japan Inc.**
**Tokyo 102-0075 (JP)**

(72) Inventors:
• **SEITA, Masaru, LeaRonal Japan Inc.**
  **Saitama-shi, Saitama 330--0031 (JP)**
• **TSUCHIDA, Hideki, LeaRonal Japan Inc.**
  **Saitama-shi, Saitama 330-0031 (JP)**

• **IMANARI, Masaaki, LeaRonal Japan Inc.**
  **Saitama-shi, Saitama 330-0031 (JP)**
• **YOMOGIDA, Koichi, LeaRonal Japan Inc.**
  **Saitama-shi, Saitama 330-0031 (JP)**
• **NAWAFUNE, Hidemi**
  **Takatsuki-shi, Osaka 569-1121 (JP)**

(74) Representative: **Kent, Venetia Katherine et al**
**Rohm and Haas (UK) Ltd**
**European Operations Patent Dept.**
**Lennig House**
**2 Mason's Avenue**
**Croydon, CR9 3NB (GB)**

(54) **RESIN COMPOSITE MATERIAL AND METHOD OF FORMING THE SAME**

(57)    A resin composite material which comprises a resin base and a metal-element-containing ingredient disposed on the surface of the base and is obtained by a wet process, characterized by having no catalyst layers. The resin composite material is superior in adhesion between the resin base and the metal-element-containing ingredient and in evenness of the thickness of the metal-element-containing coating film to the resin composite materials obtained by conventional wet processes. The formation of the resin composite material necessitates neither etching nor electroless plating unlike the conventional wet processes. Consequently, the resin composite material can be easily produced without causing pollution attributable to these treatments, such as working atmosphere worsening and the pollution of the global environment.

EP 1 364 984 A1

**Description**

Industrial field of utilization

This invention relates to a resin composite material carrying a metal-element-containing component on the surface of a resin base as well as to a method for forming the resin composite material.

Prior art

For many years, electroless plating treatment, such as plating treatment on a plastic resin base, through-hole plating treatment for a printed circuit boards, semi-additive treatment, etc., have been used to form a conducting film on a non-conducting resin material.

Recently, various compound semiconductors, such as compound semiconductors of Group 3-5 and Group 2-6 elements, etc., have been widely used as material for electronic and optical devices. Particularly, most of the compound semiconductors of Group 3-5 elements have a transition-type energy band structure and are capable of high-efficiency transformation of electricity and light. Rapid development of the practical use of semiconductors has been expected. Moreover, various alloys and metal oxides with properties suitable for a magnetic film are widely used for magnetic memory materials, magnetic head materials, optical disc memory materials, etc. Generally, the functional film of a compound semiconductor, such as magnetic film, etc., is formed on the surface of a resin base with a physical vapor-deposition method (PVD), such as vacuum-deposition method, sputtering method, ion-plating method, etc.

Electroless plating treatment uses formalin, which is a substance known to cause cancer and unsafe in the working environment. Besides, treatment of the waste generated from the electroless plating treatment will cause pollution to the environment.

In addition, electroless plating treatment consists of many steps and takes a long period of time. The process control is complicated.

Usually, the metal film formed through electroless plating treatment has low tightness of attachment to the resin base. Therefore, in order to improve the attachment, the surface of the resin base is first treated with an etching treatment using chromic acid, permanganic acid, etc., to form an uneven surface and achieve an anchoring effect on the resin surface. However, in the case of polyimide resins, etc., it is very difficult to form an uneven surface through an etching treatment and achieve an anchoring effect on the resin surface. As a result, the tightness of the attachment will be insufficient. Moreover, the reagents used in the etching treatment, such as chromic acid, permanganic acid, etc., are harmful to the environment and human body.

When a metal film is formed on a resin base through electroless plating treatment, catalyst cores of Pd, Ag, Au, etc., must be formed first on the resin base and then the plating metal is deposited on the catalyst cores to form a metal film. Therefore, for resin composite materials carrying a metal film on the surface of a resin base formed through electroless plating, there is a catalyst layer formed by a metal catalyst between the metal film and the resin base. The thickness of the metal film formed through electroless plating significantly depends on the presence of the catalyst core. The metal film is thick where the catalyst core is present, while the metal film is thin where the catalyst core is absent. In other words, if the catalyst core is not distributed evenly on the surface, the thickness of the electroless plating film will have poor uniformity.

The plastic resin used in the electroless plating treatment, such as plating treatment on a plastic resin base, through-hole plating treatment for printed circuit boards, semi-additive treatment, etc., is usually a resin material with poor electrical conductivity, such as epoxy resin, polyimide resin, etc. The resin bases made from these resin materials as well as ABS resin, poly(methyl methacrylate), polyethylene, polyvinyl chloride, etc., all have poor electrical conductivity and will easily accumulate static charge through simple friction. Discharge of the static charge may cause damage of the resin base or small particles may attach to the resin base carrying a static charge, resulting in difficulties when processing the resin base. In fact, however, most of the products made of the resin base are used in important electronic instruments and not allowed to have small damage areas or carry small particles.

In order to prevent the resin base from carrying static charges, it is necessary to avoid the separation of electric charges. However, since the mechanism for carrying electric charges is still unclear, it is very difficult to prevent the resin base from carrying static charges through its basic mechanism. Currently, in order to reduce the local electric field generated by the separation of electric charges, various measures have been adopted to prevent the accumulation of static charges. For example, a special material with a high dielectric constant is used to cover the surface or the local air is ionized to improve the leakage of the charges.

The measures to prevent the accumulation of static charges can be classified into two types of methods, temporary methods and permanent methods. In the temporary methods, a surfactant or a surfactant-containing agent is coated onto the resin surface to increase the surface hygroscopicity and reduce the surface resistance. Also, ionization of the air can be used as a temporary method. However, these methods are unable to provide a long-lasting effect and are effective only for a short period of time to overcome the difficulties during manufacturing process.

In the permanent method, a conducting substance, such as silver, copper, etc., is introduced into the resin base. As one way for introducing a conducting substance, the conducting substance can be mixed with the resin base. In this case, the resin base may lose its characteristic features, such as low conductivity, etc. In order to add a metal into a resin base while maintaining the characteristic features of the resin base, it is very important to control the amount of the metal added as well as the particle size and distribution of the metal. In other words, it is very difficult to obtain a resin composite material with desirable properties by adding a metal into the resin base as a measure for preventing static charges.

On the other hand, as another way of introducing a conducting substance into the resin base, a metal can be introduced onto the surface layer of the resin base through metal deposition, casting, plating, etc. When the metal is introduced onto the surface of the resin, the attachment of the metal to the resin base may become a problem. In addition, the amount of the metal introduced may also need to be controlled. By using the current methods listed above, however, tightness of the attachment onto the resin surface may not be sufficient. Moreover, although the surface metal layer is very effective for preventing static charging, it is very difficult to introduce a certain amount of the metal to control the resin surface conductivity at a certain level.

For example, when the resin base is formed by a polyimide resin, it is very difficult to generate an uneven surface to have an anchoring effect and usually the attachment of the metal surface layer is poor compared to other resin materials. For ABS resin, when using a solution containing chromic acid and sulfuric acid in the etching treatment, the butadiene particles will dissolve first to form round concave spots on the surface to provide an anchoring effect and improve attachment. For a resin composite of epoxy resin and polyimide resin, epoxy resin can be etched by treatment with a solution of permanganic acid to form an uneven surface, so that attachment can be improved. However, when the resin surface is treated with an etching pretreatment and then coated with a metal layer through electroless plating, it is impossible to maintain the low conductivity at a certain level. In fact, it is very difficult to introduce a trace amount of metal sufficient for preventing accumulation of static charges to the surface of a resin base.

Therefore, it is highly desirable to develop a new method for introducing a metal component onto the surface layer of resin base or for forming a metal surface layer on the resin base to replace the current method mainly based on electroless plating.

Moreover, PVD methods, such as the vacuum-deposition method, sputtering method, ion-plating method, etc., commonly used to form a functional film, such as semiconductor film, magnetic film, etc., on a resin base require special and large equipment. Therefore, it is also desirable to develop a new and easy method for the formation of a functional film, such as a semiconductor film, magnetic film, etc., on a resin base.

Furthermore, it is also desirable to develop a non-electrochargeable resin composite material, which contains a trace amount of a metal component in the surface layer of a resin base sufficient for preventing static charges while maintaining the low surface conductivity of the resin base at a certain level.

The purpose of this invention is to solve the problems mentioned above and to provide a resin composite material, which is prepared through a wet treatment and carries tightly a metal-element-containing component or film on the surface of a resin base without having a catalyst layer, usually present when the metal film is formed through electroless plating. In addition, the purpose of this invention is to provide a method for forming the resin composite material, which uses a sample treatment, such as plasma treatment or wet treatment, and will not represent a safety issue to humans and will not pollute the environment. The purpose of this invention is also to provide a resin composite material, which contains a certain amount of a metal-element-containing component in the surface layer of a resin base sufficient for preventing static charges, while maintaining the low surface conductivity of the resin base at a certain level.

Constitution of the invention

This invention concerns a resin composite material, which carries a metal-element-containing component on the surface of a resin base and is prepared through a wet treatment, characterized by containing no catalyst layer.

This invention also concerns a resin composite material, which carries a metal-element-containing component on the surface of a resin base and is prepared through a process using a metal-ion-containing liquid agent to treat a plasma-pretreated surface of the resin base to introduce a metal ion, followed by a conversion step of the metal ion.

This invention also concerns a method for forming the resin composite material described above, characterized by consisting of (1) treatment of the resin base with plasma, (2) treatment with a metal-ion-containing liquid agent, and (3) conversion to introduce the metal-element-containing component to the resin surface.

Embodiment of the invention

This invention concerns a resin composite material, which carries a metal-element-containing component on the surface of a resin base and is prepared through a wet treatment, characterized by containing no catalyst layer. In the following, this invention is explained in detail.

The resin base used in the resin composite material of this invention can be made from any type of resin material, as long as the resin material has physical and chemical properties, such as strength, corrosion resistance, etc., suitable for the purpose. There is no special limitation on the shape of the resin base. The resin base can be a molded product, which may be reinforced by a reinforcing material, such as glass fiber, etc., as well as a film coated on a base material, such as ceramics, metals, etc.

The resin material for the resin base can be, for example, a thermoplastic resin, including a polyethylene resin, such as high-density polyethylene, medium-density polyethylene, branched low-density polyethylene, linear low-density polyethylene, ultra-high molecular weight polyethylene, etc., a polyolefin resin, such as polypropylene, polybutadiene, polybutene, polybutylene, polystyrene, etc., a halogen-containing resin, such as polyvinyl chloride, polyvinylidene chloride, copolymer of vinylidene chloride/vinyl chloride polyethylene chloride, polypropylene chloride, polytetrafluoroethylene, etc., an AS resin, an ABS resin, an MBS resin, a polyvinyl alcohol resin, a polyacrylate ester resin, such as poly(methyl acrylate), etc., a polymethacrylate ester resin, such as poly(methyl methacrylate), etc., a copolymer of methyl methacrylate/styrene, a copolymer of maleic anhydride/styrene, a polyvinyl acetate resin, a cellulose resin, such as cellulose propionate, cellulose acetate, etc., an epoxy resin, a polyimide resin, a polyamide resin, such as nylon, etc., a polyamide-imide resin, a polyarylate resin, a polyether-imide resin, a polyether-ether-ketone resin, a polyethylene oxide resin, a polyester resin, such as PET, etc., a polycarbonate resin, a polysulfone resin, a polyvinyl ether resin, a polyvinyl butyral resin, a polyphenylene ether resin, such as polyphenylene oxide, etc., a polyphenylene sulfide resin, a poly(butylene terephthalate) resin, a polymethylpentene resin, a polyacetal resin, a copolymer of vinyl chloride/vinyl acetate, a copolymer of ethylene/vinyl acetate, a copolymer of ethylene/vinyl chloride, as well as copolymers or blends of these resin materials, etc., a thermosetting resin, including an epoxy resin, a xylene resin, a guanamine resin, a poly(diallyl phthalate) resin, a poly(vinyl ester) resin, a phenolic resin, an unsaturated polyester resin, a furan resin, a polyimide resin, a polyurethane resin, a polymaleic acid resin, a melamine resin, a polyurea resin, as well as copolymers or blends of these resin materials, etc. However, it is preferable to use an epoxy resin, a polyimide resin, a polyvinyl resin, a phenolic resin, a nylon resin, a polyphenylene ether resin, a polypropylene resin, a fluorine-containing resin, and an ABS resin. It is more preferable to use an epoxy resin, a polyimide resin, a polyphenylene ether resin, a fluorine-containing resin, and an ABS resin. It is more preferable to use an epoxy resin and a polyimide resin. Moreover, the resin base can be formed by either a single resin material or a blend of multiple resins. The surface treated previously with plasma can be the direct surface of the resin base as well as a surface layer formed by the resin material through coating or laminating on a base of other resin materials.

The metal-element-containing component in the resin composite material of this invention is a component containing either a metal element or a metal compound. The metal can be either a single metal element or an alloy formed by two or more metals. The alloy can be a solid solution formed by multiple metals and a sample amorphous mixture of multiple metals as well as a combination of multiple states of mixed metals. The metal compound can be a compound formed by multiple metals or by one or more metals with one or more non-metal elements. The metal-element-containing component may contain one metal compound or a mixture of multiple metal compounds. The single metal element, the metal can be, for example, Sc, Ti, V, Cr, Mn, Fe, Co, Ni, Cu, Zn, Ga, Ge, As, Se, Y, Zr, Nb, Mo, Tc, Ru, Rh, Pd, Ag, Cd, In, Sb, Te, Hf, Ta, W, Re, Os, Ir, Pt, Au, Hg, Tl, Pb, Bi, Po, etc., as well as their alloys.

As the component of the metal compound, the metal can be, for example, Sc, Ti, V, Cr, Mn, Fe, Co, Ni, Cu, Zn, Ga, Ge, As, Se, Y, Zr, Nb, Mo, Tc, Ru, Rh, Pd, Ag, Cd, In, Sb, Te, Hf, Ta, W, Re, Os, Ir, Pt, Au, Hg, Tl, Pb, Bi, Po, etc., as well as their alloys. However, it is preferable to use V, Cr, Mn, Fe, Co, Ni, Cu, Ga, As, Se, Mo, Ru, Rh, Pd, Ag, Cd, In, Sb, Te, Os, Ir, Pt, Au, Hg, Pb, and Bi as well as their alloys. It is more preferable to use V, Mn, Co, Ni, Cu, Ga, As, Se, Mo, Pd, Ag, In, Sb, Te, Pt, Au, Hg, and Bi as well as their alloys. It is more preferable to use Co, Ni, Cu, Pd, Ag, Pt, and Au as well as their alloys.

The metal-element-containing component introduced onto the resin base in the non-electrochargeable resin composite material of this invention can be present on the resin base in any form. For example, fine particles of the metal-element-containing component can be present on the resin base but isolated from each other. Also, the metal-element-containing component may form a film or a net on the resin base or is present simultaneously in several different forms on the resin base. When the metal-element-containing component is present as particles, the size and distribution of the particles should be determined based on the requirements for the product. When the metal-element-containing component is present as a film, the thickness of the film should be determined based on the requirements for the product. The metal-element-containing component can be introduced through a process consisting of (1) treatment of the resin base with plasma, (2) treatment with a metal-ion-containing liquid agent, and (3) conversion to introduce the metal-element-containing component to the resin surface. By changing the conditions used in steps (1) - (3), the state of the metal-element-containing component present on the resin base can be adjusted.

The surface of the resin composite material formed by the metal-element-containing component on the resin base may have various functions, such as conductivity, semiconductor properties, magnetic properties, no electrostatic chargeability, etc., depending on the type, quantity, and state of the metal or metal compound introduced onto the surface of the resin base. For example, when the metal-element-containing component is present on the surface of the resin base as a film, the film may become a functional film with various functions, such as conductivity, semiconductor properties, magnetic properties, no electrical chargeability, etc., depending on the type, quantity, and state of the metal or metal compound introduced onto the surface of the resin base. If a film with magnetic properties is needed, a metal film containing an alloy of Co-Ni, Co-Cr, Co-V, Ni-Mo-Fe, Gd-Co, Mn-Bi, Mn-Cu-Bi, Pt-Co, Co-Cr, etc., can be used.

In this invention, the metal compound can be a compound formed by multiple metals or by one or more metals with one or more non-metal elements. The metal compound can be, for example, a metal arsenide, such as GaAs, InAs, etc., a metal antimonide, such as GaSb, InSb, etc., a metal selenide, such as ZnSe, CdSe, HgSe, etc., a metal telluride, such as CdTe, HgTe, etc., a metal sulfide, such as CuS, PdS, CdS, ZnS, AgS, etc., a metal oxide, such as $Fe_2O_3$, $Fe_3O_4$, CrO, Co-Ni-O, $MnO$-$ZnO$-$Fe_2O_3$, etc., as well as a metal hydroxide, a metal nitride, a metal silicide, a metal boride, etc.

As the metal compound, however, it is preferable to use a metal arsenide, such as GaAs, InAs, etc., a metal antimonide, such as GaSb, InSb, etc., a metal selenide, such as ZnSe, CdSe, HgSe, etc., a metal telluride, such as CdTe, HgTe, etc., a metal sulfide, such as CuS, PdS, CdS, ZnS, AgS, etc., a metal oxide, such as $Fe_2O_3$, $Fe_3O_4$, CrO, Co-Ni-O, $MnO$-$ZnO$-$Fe_2O_3$, etc., or a mixture of these metal compounds. It is more preferable to use GaAs, GaSb, InAs, InSb, ZnSe, CdSe, CdTe, HgSe, HgTe, CuS, PdS, CdS, ZnS, AgS, $Fe_2O_3$, $Fe_3O_4$, CrO, Co-Ni-O, $MnO$-$ZnO$-$Fe_2O_3$, etc., or a mixture of these metal compounds.

The film formed by a metal arsenide, such as GaAs, InAs, etc., a metal antimonide, such as GaSb, InSb, etc., a metal selenide, such as ZnSe, CdSe, HgSe, etc., a metal telluride, such as CdTe, HgTe, etc., a metal sulfide, such as CdS, ZnS, etc., is useful as a compound semiconductor film. The film formed by a metal sulfide, such as CuS, PdS, etc., is useful as a conducting film. Moreover, the film formed by a metal oxide, such as $Fe_2O_3$, $Fe_3O_4$, CrO, Co-Ni-O, $MnO$-$ZnO$-$Fe_2O_3$, etc., is useful as a magnetic film.

In this invention, the resin material used for the resin base and the metal or metal compound used in the metal-element-containing component can be selected freely. When the metal-element-containing component is a metal, the combination of resin material and metal should contain a resin material selected from epoxy resin, polyimide resin, polyvinyl resin, phenolic resin, nylon resin, polyphenylene ether resin, polypropylene resin, fluorine-containing resin, and ABS resin as well as a mixture of these resin materials and a metal selected from V, Mn, Co, Ni, Cu, Ga, As, Se, Mo, Pd, Ag, In, Sb, Te, Pt, Au, Hg, and Bi as well as an alloy of these metals. Preferably, the resin material is selected from epoxy resin, polyimide resin, polyvinyl resin, phenolic resin, nylon resin, polyphenylene ether resin, polypropylene resin, fluorine-containing resin, and ABS resin as well as a mixture of these resin materials and the metal is selected from V, Mn, Co, Ni, Cu, Ga, As, Se, Mo, Pd, Ag, In, Sb, Te, Pt, Au, Hg, and Bi as well as an alloy of these metals. More preferably, the resin material is selected from epoxy resin, polyimide resin, polyphenylene ether resin, and ABS resin as well as a mixture of these resin materials and the metal is selected from V, Mn, Co, Ni, Cu, Ga, As, Se, Mo, Pd, Ag, In, Sb, Te, Pt, Au, Hg, and Bi as well as an alloy of these metals.

When the metal-element-containing component is a metal sulfide, a preferable combination of resin and metal sulfide contains a resin material selected from epoxy resin, polyimide resin, polyphenylene ether resin, fluorine-containing resin and ABS resin as well as a mixture of these resin materials, and a metal sulfide selected from CuS, CdS, ZnS, PdS, $Ag_2S$, $As_4S_4$, $As_2S_3$, $As_2S_6$, TeS, and $TeS_3$ as well as a mixture of these metal sulfides. Preferably, the resin material is selected from epoxy resin, polyimide resin, polyphenylene ether resin, and ABS resin as well as a mixture of these resin materials and the metal sulfide is selected from CuS, CdS, ZnS, PdS, and $Ag_2S$ as well as a mixture of these metal sulfides.

When the metal-element-containing component is a metal oxide, a preferable combination of resin and metal oxide contains a resin material selected from epoxy resin, polyimide resin, and fluorine-containing resin as well as a mixture of these resin materials, while the metal oxide is selected from FeO, NiO, CoO, and MnO as well as a mixture of these metal oxides. Preferably, the resin material is selected from epoxy resin and polyimide resin as well as a mixture of these resin materials and the metal oxide is selected from FeO, NiO, CoO, and MnO as well as a mixture of these metal oxides.

The metal-element-containing component introduced onto the surface of a resin base can be treated with various treatments commonly used for resin materials. For example, when the metal-element-containing component forms a film on the resin surface, the film can be used as a prime film for various plating treatments if the film is a conducting film. More specifically, after a conducting film is formed with the method of this invention, electrolytic copper plating can be carried out through a simple panel-plating process. Moreover, when using the semiadditive method, after a conducting film is formed, a series of treatments, such as electroless copper plating, resistance pattern formation, electrolytic copper plating, solder plating treatment, resistance removing treatment, solder peeling treatment, etc., can be carried out according to a certain sequence. If necessary, degreasing treatment, aqueous washing, etching treatment, anticorrosive treatment, etc., may also be used.

If the metal-element-containing component is present on the resin surface as a semiconductor film, the resin composite material can be used as a base material for electronic devices or optical devices. If the metal-element-containing component is present on the resin surface as a magnetic film, the resin composite material can be used as a base material, as a magnetic memory medium, a magnetic head material, an optical disc memory material, etc.

In this invention, the wet treatment is a process using a liquid phase to introduce the metal-element-containing component (a metal, a metal ion, a metal compound, or other substances containing a metal) to the resin base. As described below, the method of this invention uses a wet treatment. Moreover, in contrast to the wet treatment, PVD methods, such as vacuum-deposition method, sputtering method, ion-plating method, etc., belong among the dry treatments, which use a gas-phase reaction to introduce a metal to a resin base.

The resin composite material of this invention is characterized by containing no catalyst layer. When a metal film is formed on a resin base through electroless plating, the surface of the resin base is first treated with a catalyst, such as Pd and Sn, Cu, etc., to form catalyst cores of Pd and tin salt or Cu. Next, the metal film is formed by precipitating the plating metal on the catalyst cores. In other words, the catalyst is a layer formed by the catalyst on the resin base. The catalyst cores may not be present as a layer, as long as the catalyst cores are distributed evenly on the resin base. Therefore, the resin composite material carrying a metal film on a resin base formed through electroless plating contains catalyst cores or a catalyst layer between the resin base and the metal film. On the other hand, however, the resin composite material of this invention is different from the resin composite material formed through electroless plating and contains no a catalyst layer between the resin base and the metal-element-containing component.

In the resin composite material of this invention, the metal-element-containing component introduced onto the surface of a resin base has a uniform distribution and tight attachment to the resin base compared to the metal film formed through electroless plating. In addition, when the metal-element-containing component forms a film on a resin base, the film has a uniform thickness compared to the metal film formed electroless plating. Although this invention should not be limited by any theoretical consideration, the excellent properties of the resin composite material of this invention are mainly due to the absence of the catalyst layer. In other words, in the electroless plating process, the metal precipitates on the catalyst cores present on the resin base to form a metal film. Therefore, the places where the catalyst cores are present will have a thicker metal film, while the places where the catalyst cores are absence will have a thinner metal film. If the catalyst cores are not evenly distributed, the thickness of the metal film formed will have poor uniformity, and it is very difficult to control the film thickness when the film thickness is in the range of 200 nm or lower. On the other hand, in the resin composite material of this invention, the metal does not precipitate on the catalyst cores, so that the metal film obtained will not have a uniformity problem for the thickness, as in the resin composite material formed through electroless plating. Particularly, in the method of this invention, the film of the metal-element-containing component is formed through the treatment of a resin base surface with plasma and then treatment with a liquid agent containing a metal ion to introduce the metal ion to the resin surface, followed by conversion of the metal ion. When the surface of a resin base contains functional groups capable of ion exchange, the ions on the ion-exchangeable groups will be replaced by the metal ion introduced. Therefore, the metal-element-containing component will be distributed uniformly on the surface of the resin base and have tight attachment on the surface. In fact, by using the method of this invention, a uniform metal film with a thickness of 50 - 200 nm can be obtained.

In the resin composite material of this invention, the attachment of the metal-element-containing component on the resin base is significantly improved. When the metal-element-containing component is present as a film, tightness of the attachment of the metal-element-containing component on the resin base can be determined by film peel strength and tape peel test. In this invention, when the film formed by the metal-element-containing component is a metal film, the film peel strength should be in the range of 3 N/cm or higher, preferably 5 N/c or higher, more preferably 8 N/c or higher. Moreover, when the film formed by the metal-element-containing component is a metal sulfide film or a metal hydroxide {oxide? - Translator} film, the film should show no peeling in the tape peel test.

The details about of the film peel strength and tape peel test will be described below.

The resin composite material of this invention is not electrically chargeable. In other words, the resin composite material of this invention has a surface resistance value in a certain range, capable of preventing the resin composite material from carrying static charges. In the resin composite material of this invention, the resin base originally has a high surface resistance value. However, in order to prevent the resin composite material from carrying static charges, the surface resistance value of the resin composite material of this invention should be in the range of $10^6$ - $10^{11}$ $\Omega$/, preferably $10^7$ - $10^9$ $\Omega$/. For example, a conducting material usually has a surface resistance value in the range of $10^{-6}$ - $10^2$ $\Omega$/, and a semiconducting material usually has a surface resistance value in the range of $10^{-2}$ - $10^9$ $\Omega$/.

Usually, a not electrically chargeable resin composite material is prepared by adding a small amount of a substance with a high electrical conductivity to an insulating resin material. Therefore, it is preferable to introduce a metal-element-containing component into a resin at a concentration lower than a certain level.

In this invention, the ratio of the resin composite material surface resistance/the metal-element-containing component resistivity is set in a certain range to control the amount of the metal-element-containing component present on the surface of the resin composite material. The ratio should be in the range of $10^{12}$-$10^{17}$ (1/( ·cm), preferably $10^{13}$

$-10^{15}$ (1/( ·cm). Since each metal-element-containing component has its own intrinsic resistance value, the amount of the metal-element-containing component present on the surface of the resin composite material can be determined based on the resistance value of the metal-element-containing component. For example, when the metal-element-containing component is copper, the amount of the metal-element-containing component present on the surface of the resin composite material should be in the range of 0.005 - 5 $g/m^2$ of surface area, preferably 0.01 - 0.3 $g/m^2$ of surface area.

In this invention, the resistivity in $\Omega$·cm is the inverse of the electrical conductivity, which is an intrinsic value for each metal-element-containing component.

The surface resistance value in $\Omega$/ is determined with the following method. First, a conducting paint is coated on the test specimen with width = 1 mm and length = 5 mm. Resistance value R of the part not coated with the conducting paint (length = 5 mm) is measured. The surface resistance value is then calculated using the following equation.

$$\text{Surface electric resistance value } (\Omega/\ ) = R(\Omega) \times width(mm)/length(mm)$$

The resin composite material of this invention can be prepared with a method consisting of (1) treatment of the resin base with plasma, (2) treatment with a metal-ion-containing liquid agent, and (3) conversion to form a film of the metal-element-containing component on the resin surface. In the following, each step is explained in detail.

Step (1): In the method for the preparation of the resin composite material of this invention, first, the resin base is treated with plasma. Through the plasma treatment, the surface of the resin base is etched. Due to the high activation energy, certain constituent elements in the resin base are removed (extraction of proton, etc.) to form branches, bridges, and unsaturation and to introduce groups capable of ion-exchange. In this invention, the group capable of ion-exchange introduced into the resin base can be ion-exchanged with metal ions in step (2).

In this invention, the group capable of ion-exchange, introduced through plasma treatment, can be ion-exchanged with either a cation or an anion. Good examples of the group capable of ion-exchange are carboxyl group, thiocarboxyl group, dithiocarboxyl group, sulfo group, sulfino group, sulfeno group, haloformyl group, carbamoyl group, hydrazinocarbonyl group, amidino group, cyano group, nitro group, isocyano group, cyanato group, isocyanato group, thiocyanato group, isothiocyanato group, formyl group, hydroxyl group, carbonyl group, thioformyl group, thioxo group, mercapto group, hydroperoxyl group, amino group, imino group, hydrazino group, diazo group, azido group, nitro. group, nitroso group, etc. Preferably, the group capable of ion-exchange is a carboxyl group, a hydroxyl group, a carbonyl group, an amino group, an imino group, a cyano group, and a nitro group. When the group is a cation-exchanger group, the group exchanges with a metal cation in step (2). When the group is an anion-exchanging group, the group exchanges with an anion in step (2).

The group capable of ion-exchange introduced through the plasma treatment can be, for example, an oxygen-containing group, such as a carboxyl group, hydroxyl group, carbonyl group, etc., formed when using oxygen or air plasma, a nitrogen-containing group, such as amino group, imino group, etc., formed using when mixed gas plasma containing ammonia, nitrogen, and hydrogen, or a nitro group, formed when using a nitrogen gas plasma. In addition to the gases mentioned above, other types of ion-exchanging groups can be introduced by using different gases or gas mixtures. Through the plasma treatment, the surface hydrophilicity of the resin base will be improved in most cases, since ion-exchanging groups are introduced into the resin surface.

The plasma treatment can be carried out with any common method as long as the goal of introducing a suitable metal-element-containing component to the resin base can be achieved. For example, reduced-pressure plasma treatment, normal-pressure plasma treatment, etc., can be used. In consideration of the capability of handling a large size resin base and using a continuous process, it is preferable to use normal pressure plasma treatment carried out in the atmosphere under normal pressure (about 1 atmosphere). There is no special limitation on the equipment used in the plasma treatment. Any commonly used equipment, such as the equipment for reduced pressure plasma treatment, etc., is suitable for this purpose. The conditions used for the plasma treatment should be determined based on the resin base, the metal-element-containing film to be formed, etc. When using the reduced-pressure plasma treatment, the discharge current is usually in the range of 30- 200 mA at 20 kHz, the pressure is usually in the range of 0.1 - 0.3 Pa, and the treatment time is usually in the range of 1 - 30 minutes, and the reforming agent may contain oxygen, argon, $CO_2$, and $N_2$. Preferably, the discharge current is in the range of 50 - 150 mA at 20 kHz, the pressure is in the range of 0.1 - 0.3 Pa, the treatment time is in the range of 10 - 20 minutes, and the reforming agent contains oxygen, argon, $CO_2$, and $N_2$. When using the normal pressure plasma treatment, the pulse voltage is usually in the range of 70 - 100 kV, the discharging distance is usually in the range of 1 - 3 cm, and the treatment time is usually in the range of 0.5 - 100 minutes. Preferably, the pulsed voltage is in the range of 80 - 90 kV, the discharging distance is in the range of 1 - 2 cm, and the treatment time is usually in the range of 1 - 30 minutes. Moreover, the plasma treatment temperature should be selected based on other conditions. For example, room temperature (about 20 - 30°C) is preferable in consideration of the stability and processability of the resin base. The atmosphere used for the plasma treatment may contain H, N, O, $N_2$, $O_2$, $O_3$, etc. Preferably, the atmosphere contains oxygen when using normal pressure plasma treatment.

In this invention, there is no special limitation on the method used to introduce an ion-exchanging group to the resin base surface through the plasma treatment. Depending on the resin base used and the type of the group to be introduced, any common method suitable for the purpose can be used. In the following, a method for introducing a carboxyl group is described as an example for the acidic group. Thus, a polyimide film is set on a turning table in a microwave type low-temperature oxygen plasma treatment chamber. The pressure in the chamber is then reduced to 0.13 Pa or lower using a vacuum pump. While the vacuum pump is still operating, oxygen gas is introduced at a rate of 10 mL/min and the polyimide resin film is irradiated under discharging at a current of 50 mA for 5 minutes, to form carboxyl groups on the resin surface as a cation-exchanger group. Moreover, the polyimide resin film can also be treated by applying a high pulsed voltage of 70 - 100 kV for 1 minute through a narrow space of 1 cm, to form carboxyl groups on the resin surface as a cation-exchanger group.

In step (1), the resin base can be treated before or after the plasma treatment with an agent for introducing an ion-exchanging group by contacting the resin surface with the agent. The treatment conditions, such as contacting method, contacting time and temperature, etc., should be determined based on the type and amount of the ion-exchange group to be introduced as well as on the type of the base resin. For example, the resin base is contacted with the agent through dipping. The treatment with the agent for introducing the ion-exchanging group can be carried out just once or repeatedly with the same or different agents.

In this invention, the agent for introducing an ion-exchanging group can be any agent capable of introducing an ion-exchanging group onto the surface of the base resin. Good examples of the agent for introducing an ion-exchanging group are Lewis acids or Lewis bases. More specifically, the agent for introducing an ion-exchanging group can be, for example, a sulfonating agent, such as sulfuric acid, fuming sulfuric acid, sulfur trioxide, chlorosulfuric acid, sulfuryl chloride, etc., an acid, such as hydrochloric acid, nitric acid, acetic acid, formic acid, citric acid, lactic acid, etc., a base, such as sodium hydroxide, potassium hydroxide, ammonia, etc., as well as an aminating agent, a nitrating agent, a cyanating agent, an oxidizing agent, etc. Among these agents, sulfuric acid, sodium hydroxide, and potassium hydroxide are preferable.

Step (2): Next, step (2) of the method for the preparation of resin composite material of this invention is explained. In step (2), the resin base treated with plasma in step (1) is further treated with a liquid agent containing a metal ion. In the treatment, a metal ion is introduced onto the surface of the resin base through ion-exchange of the metal ion with the group capable of ion-exchange introduced in step (1) on the surface of the resin base.

The liquid agent containing a metal ion is a solution containing, as a metal ion, the metal component capable of forming the metal-element-containing component of the target resin composite material. For example, when the metal-element-containing component is a metal, a solution containing a suitable metal ion can be used. When the metal-element-containing component is an alloy, a solution containing suitable metal ions for all constituent metals or a part of constituent metals of the alloy can be used. When using a solution containing suitable metal ions for a part of the constituent metals of the alloy in step (2), a treatment with a solution containing suitable metal ions of the remaining constituent metals of the alloy can be included in the subsequent step (3) to obtain the desirable alloy. Moreover, when the metal-element-containing component is a metal compound, such as a metal oxide or metal sulfide, a solution containing a metal ion corresponding to the metal component in the metal compound can be used in the treatment.

In this invention, the metal ion present in the treatment solution can be a complex ion. In this case, the complex ion can be either a complex cation or a complex anion. The metal ion solution is usually an aqueous solution of a metal ion. However, depending on the metal ion, a solution in an organic solvent, such as methanol, etc., or in a solvent mixture of water with an organic solvent may also be used. If necessary, the treatment solution may also contain a stabilizer for maintaining the pH value, a complexing agent for preventing the metal ion from precipitation, etc.

The metal ion present in the treatment solution can be the ions of the metal elements listed above.

The treatment solution containing a metal ion can be prepared from a compound or a salt of the corresponding metal. There is no special limitation on the compound and salt used for this purpose. Depending on the types of the metal, a suitable metal compound or metal salt soluble in the solvent can be used. Good examples of the metal compound and metal salt are carboxylate salts, such as formate salt, acetate salt, chloroacetate salt, oxalate salt, etc., as well as sulfate salt, sulfite salt, thiosulfate salt, fluoride, chloride, bromide, iodide, nitrate salt, nitrite salt, hydrogen carbonate salt, hydroxide, phosphate salt, phosphite salt, pyrophosphate salt, metaphosphate salt, selenate salt, thiocyanate salt, tetrafluoroborate salt, triethylenediamine chloride {sic!}, cyanide, chlorate, perchlorate, bromate, perbromate, iodate, periodate, etc. Among these compounds and salts, sulfate salt, chloride, and nitrate salt are preferable, and the sulfate salt is more preferable.

In the treatment solution containing a metal ion, the concentration of the metal ion should be in the range of 0.01 - 1 mol/L, preferably 0.03 - 0.1 mol/L. Moreover, when the metal-element-containing component film is formed by an alloy or a metal compound mixture containing a multiplicity of metals, the solution should contain the corresponding metal ions of the multiple metals at a molar ratio the same as the molar ratio in the alloy or metal compound mixture.

In this case, the total concentration of the corresponding metal ions of the multiple metals should be in the range described above.

In this invention, there is no special limitation on the method used in the treatment of the resin base with the treatment solution containing a metal ion. For example, the resin base treated previously with plasma in step (1) can be dipped into a treatment solution containing a metal ion. The dipping treatment is usually carried out at a temperature of 20 - 80°C, preferably 25 - 60°C, for 1 - 10 minutes, preferably 3 - 5 minutes. After the dipping treatment using a treatment solution containing a metal ion, if necessary, the resin base can be further washed with water and dried.

After the treatment using a solution containing a metal ion, since the pH value of the treatment solution used in step (3) decreases as the treatment progresses, hydroxyl ions are usually added.

Therefore, the pH value of the treatment solution should be adjusted to the range of weakly acidic to neutral, preferably pH 2 - 6, more preferably pH 3 - 4.

Step (3): Finally, step (3) of the method for the preparation of resin composite material of this invention is explained. In step (3), the metal ion introduced onto the surface of the resin base in step (2) is converted to introduce a metal-element-containing component onto the surface of the resin base. In this invention, conversion means a change in the binding state of the metal element. Therefore, it is necessary to form a metal-element-containing component through the conversion in this invention, and any conversion not involving formation of a metal-element-containing component is not included in the conversion of this invention. The conversion treatment of the metal ion should be carried out with a method selected based on the type of the metal-element-containing component to be formed as the final target of this invention. For example, the conversion treatment in step (3) is a reduction treatment when the metal-element-containing component is a metal, but the treatment is done with a sulfide-containing solution when the metal-element-containing component is a metal sulfide. Furthermore, the conversion treatment is a treatment with a hydroxide-containing solution when the metal-element-containing component is a metal hydroxide.

When the metal ion conversion treatment is a reduction treatment, there is no special limitation on the method for the reduction treatment, as long as the reduction treatment is able to reduce the metal ion introduced onto the surface of the resin base in step (2). For example, the resin base treated in step (2) can be dipped into a solution containing a reducing agent.

In this invention, there is no special limitation on the reducing agent used to reduce the metal ion introduced onto the surface of the resin base, as long as the reducing agent is able to reduce the metal ion to form the corresponding metal deposit. The solution containing a reducing agent is usually an aqueous solution. The reducing agent can be, for example, sodium borohydride, dimethylaminoborane (DMAB), trimethylaminoborane (TMAB), hydrazine, formaldehyde, and their derivatives, as well as sulfite salts, such as sodium sulfite, etc., hypophosphite salts, such as sodium hypophosphite, etc. The concentration of the reducing agent in the aqueous solution should be in the range of 0.0025 - 3 mol/L, preferably 0.01 - 1.5 mol/L. The reduction is carried out at a temperature of 20 - 90°C, preferably 25 - 80°C, for 1 - 60 minutes, preferably 20 - 40 minutes.

Moreover, as the reducing agent, selenourea, arsenous acid, antimony(III) chloride, tellurium chloride, etc., may also be used. When using these reducing agents, not only the metal ion adsorbed chemically by the acidic group will be reduced, but also the metal component in the reducing agent, such as Se in the selenourea, As in the arsenous acid, Sb in the antimony(III) chloride, or Te in the tellurium chloride will react with the reduced metal to form a metal compound. The reducing agent, such as selenourea, arsenous acid, etc., is used under the same conditions as for the other reducing agents and can also be used together with other reducing agents. Particularly, when using selenourea as the reducing agent, it is preferable to use a combination with other reducing agents, since the combination with other reducing agents will improve the stability of the aqueous solution of selenourea.

If the reduction treatment cannot be completed by using the aqueous solution of the reducing agent listed above, the reduction treatment can be carried out using a solution containing a more powerful reducing agent in an organic solvent. The powerful reducing agent used in an organic solvent can be, for example, a metal, such as Li, Na, K, etc., in liquid ammonia, amines, etc., as the solvent as well as a trialkylaluminum in dioxane, toluene, tetrahydrofuran, etc., as the solvent, a tin hydride, such as tri-n-butyltin, etc., in ether, benzene, toluene, etc., as the solvent. When using the organic solution of these reducing agents in the reduction treatment, the treatment conditions, such as reducing agent concentration, etc., should be selected based on the type of the metal salt to be reduced, to achieve complete reduction and metal deposition.

The reduction treatment to introduce a metal-element-containing component into the base resin can also be carried out through irradiation of the resin base under electromagnetic radiation. The reduction treatment using electromagnetic radiation utilizes the activation energy from the electromagnetic radiation to reduce the metal ion to metal. There is no special limitation on the electromagnetic radiation used for this purpose, as long as the electromagnetic radiation is capable of providing the activation energy required by the reduction of the metal ion. However, it is preferable to use ultraviolet light. The power of the electromagnetic radiation should be in the range of 10 W - 10 kW, preferably 100 W - 1 kW for a short treatment. The treatment time should be in the range of 30 seconds - 1 hour, preferably 1 minute - 10 minutes.

If necessary, the irradiation using an ultraviolet light can be carried out through a glass mask. When using a glass mask, the metal ions will be reduced only for a part of the resin base, such as circuit, etc., not covered by the glass mask. In this invention, there is no special limitation on the mask used for this purpose, as long as the mask is able to block the ultraviolet light. Moreover, the metal ion present in the surface of the resin base not reduced when covered by the mask can be removed easily by washing with dilute nitric acid solution, etc. As a result, a resin composite material carrying a metal film directly formed on the surface of a resin base with a desirable pattern can be obtained without using etching treatment and electroless plating.

When the metal-element-containing component is a metal sulfide, the resin base treated with a solution containing a metal ion in step (2) is further treated with a solution containing a sulfide. There is no special limitation on the sulfide used in the treatment, as long as the sulfide is able to generate sulfide ions in the solution. Good examples of the sulfide are sodium sulfide, potassium sulfide, ammonium sulfide, etc.

The concentration of the sulfide in the sulfide-containing solution should be in the range of 0.05 - 1.2 mol/L, preferably 0.1 - 0.5 mol/L. If the concentration of the sulfide in the solution is lower than 0.05 mol/L, deposition of the metal sulfide in the surface of the resin base will become difficult. On the other hand, however, if the concentration of the sulfide in the solution is higher than 1.2 mol/L, no further effect can be obtained, but the cost will increase. The sulfide-containing solution can be an aqueous solution or a solution in an organic solvent or in a solvent mixture of water with an organic solvent.

The pH value of the sulfide-containing solution should be in the range of weakly acidic - basic, preferably pH 4-11, more preferably pH 6 - 10.

The treatment with the sulfide-containing solution can be carried out by dipping the resin base containing the metal ion on the resin surface, introduced in step (2), into the sulfide-containing solution. The treatment temperature should be in the range of 20 - 80°C, preferably 25 - 60°C. If the treatment temperature is lower than 20°C, the formation of metal sulfide will be incomplete. However, if the treatment temperature is higher than 80°C, the sulfide-containing solution may become unstable. The treatment time is usually in the range of 2- 30 minutes.

When the metal-element-containing component is a metal hydroxide, the resin base treated with a solution containing a metal ion in step (2) is further treated with a solution containing a hydroxide, followed by a heat treatment to form a metal hydroxide {It should be metal oxide. — Translator} on the surface of the resin base.

There is no special limitation on the hydroxide used in the treatment, as long as the hydroxide is able to generate hydroxyl ions in the solution. Good examples of the hydroxide are NaOH, $NH_4OH$, KOH, etc.

The concentration of the hydroxide in the hydroxide-containing solution should be in the range of 0.025 - 12 mol/L, preferably 0.1 - 5 mol/L. If the concentration of the hydroxide in the solution is too low, the formation of the metal hydroxide on the surface of the resin base will be insufficient. On the other hand, however, if the concentration of the hydroxide in the solution is too high, the solution may cause degradation of the resin base. The hydroxide-containing solution can be an aqueous solution or a solution in an organic solvent or in a solvent mixture of water with an organic solvent.

The treatment with the hydroxide-containing solution can be carried out by dipping the resin base containing the metal ion in the resin surface introduced in step (2) into the hydroxide-containing solution. The treatment temperature should be in the range of 10 - 80°C, preferably 20 - 50°C. If the treatment temperature is too low, the formation of the metal hydroxide will be incomplete. However, if the treatment temperature is too high, the resin base may undergo degradation. The treatment time is usually in the range of 2- 30 minutes.

Through the treatment with a hydroxide-containing solution, a metal hydroxide is formed in the surface of the resin base. Then, the resin base is further treated with heat treatment to form a metal oxide through dehydration. The method for the heat treatment should be selected based on the heat resistance of the resin base. It is preferable to use a high temperature as long as the heat treatment will not cause degradation of the resin base. For example, for a resin base containing mainly an epoxy resin, the heat treatment should be carried out at a temperature of 80 - 150°C. For a resin base containing mainly a polyimide resin, the heat treatment should be carried out at a temperature of 80 - 180°C. The treatment time is usually in the range of 30 - 120 minutes. There is no special limitation on the atmosphere used for the heat treatment. The heat treatment can be carried out in air. However, for example, in case of $Fe_3O_4$, the heat treatment should be carried out in a reducing atmosphere, such as hydrogen atmosphere, etc., to prevent the progression of oxidation. The atmosphere used for the heat treatment should be selected based on the nature of the metal-element-containing component to be formed in the surface of the resin base.

## Practical Examples

Method for the measurement of peel strength

First, a metal-element-containing thin film was formed on the surface of a resin base. Then, a copper film with a thickness of 25 - 30 micron was further formed by copper sulfate plating. After annealing treatment at 120°C for 1 hour, the film was cut into strips with a width of 1 cm. The peel strength (90° peel strength) was determined on a tensile tester by vertical peeling at a rate of 30 mm/min.

Method for the tape peel test

The measurement was carried out according to the method listed in ASTM D-3359-95a. Thus, cross-cutting with an interval of 1 mm was made using a knife to generate 100 squares with a size of 1 mm. A Nichiban cellophane tape with a width of 18 mm was attached and then removed rapidly. The number of the squares removed was counted.

Practical Example 1

Formation of a copper thin film on a polyimide resin

A polyimide film (Capton Film 200-H, Torei-Du Pont Co.) with a size of 5 cm x 10 cm was first treated in a normal-pressure plasma system (Nippon Paint Co.) at 80 kV for 10 minutes using a distance of 2 cm between the electrodes. The film was then dipped into an aqueous solution containing 0.05 mol/L of copper sulfate at room temperature for 5 minutes and washed with water. The film was further dipped into an aqueous solution containing 0.02 mol/L of sodium borohydride at room temperature for 30 minutes and washed with water and dried. The copper-containing film thus obtained showed a uniform gloss. Next, copper plating was carried out using a commercially available copper sulfate plating bath to form a copper plating film with a thickness of 25 $\mu$m. The film was washed with water. A treatment using Entech Cu-56 (Meltex Co.) was carried out at room temperature for 20 seconds to prevent oxidation of the copper film, followed by washing with water and drying. After an annealing treatment at 120°C for 1 hour, the peel strength of the copper film was measured. As a result, the peel strength was found to be 10 N/cm, suggesting tight attachment of the film onto the resin surface.

Composition of the copper sulfate plating bath:

| Component | Content |
|---|---|
| Copper sulfate | 75 g/L |
| Sulfuric acid | 190 g/L |
| Chloride ion | 50 mg/L |
| Additive | some |

Practical Example 2

Formation of a copper thin film on an epoxy resin

An epoxy resin film (1 mm thickness, Matsushita Denko Co.,) of a size of 5 cm x 10 cm was first treated in a normal-pressure plasma system at 80 kV for 10 minutes using a distance of 2 cm between the electrodes. The film was then dipped into an aqueous solution containing 0.05 mol/L of copper acetate at room temperature for 5 minutes and washed with water. The film was further dipped into an aqueous solution containing 0.02 mol/L of sodium borohydride at room temperature for 20 minutes and washed with water and dried. The copper-containing film thus obtained showed a uniform gloss. Next, copper plating was carried out using a commercially available copper sulfate plating bath to form a copper plating film with a thickness of 25 $\mu$m. The film was washed with water. A treatment using Entech Cu-56 (Meltex Co.) was carried out at room temperature for 20 seconds to prevent oxidation of the copper film, followed by washing with water and drying. After an annealing treatment at 120°C for 1 hour, the peel strength of the copper film was measured. As a result, the peel strength was found to be 12 N/cm, suggesting tight attachment of the film on the resin surface.

Practical Example 3

Formation of a copper thin film on a polyimide resin

A polyimide resin film (Capton Film 200-H, Torei-Du Pont Co.) with a size of 5 cm x 10 cm was first set on the turning table in a microwave type low-temperature oxygen plasma treatment chamber. The pressure in the chamber was then reduced to 0.13 Pa or lower using a vacuum pump. While the vacuum pump was still operating, oxygen gas was introduced at a rate of 10 mL/min and the polyimide resin film was irradiated under discharging at a current of 150 mA for 5 minutes to form carboxyl groups on the resin surface as a cation-exchanger group. The film was then dipped into an aqueous solution containing 0.05 mol/L of copper sulfate at room temperature for 5 minutes and washed with water. The film was further dipped into an aqueous solution containing 0.03 mol/L of sodium borohydride at room temperature for 10 minutes and washed with water and dried. The copper-containing film thus obtained showed a uniform gloss.

Next, copper plating was carried out using a commercially available copper sulfate plating bath to form a copper plating film with a thickness of 25 μm. The film was washed with water. A treatment using Entech Cu-56 (Meltex Co.) was carried out at room temperature for 20 seconds to prevent oxidation of the copper film, followed by washing with water and drying. After an annealing treatment at 120°C for 1 hour, the peel strength of the copper film was measured. As a result, the peel strength was found to be 9.8 N/cm, suggesting tight attachment of the film onto the resin surface.

Practical Example 4

Formation of a nickel thin film

A polyimide resin film (Capton Film 200-H, Torei-Du Pont Co.) with a size of 5 cm x 10 cm was first set on the turntable in a microwave type low-temperature oxygen plasma treatment chamber. The pressure in the chamber was then reduced to 0.13 Pa or lower using a vacuum pump. While the vacuum pump was still operating, oxygen gas was introduced at a rate of 10 mL/min and the polyimide resin film was irradiated under discharging at a current of 100 mA for 5 minutes to form carboxyl groups on the resin surface as a cation-exchanger group. The film was then dipped into an aqueous solution containing 0.02 mol/L of nickel sulfate at room temperature for 5 minutes and washed with water. The film was further dipped into an aqueous solution containing 0.02 mol/L of sodium borohydride at room temperature for 10 minutes and washed with water and dried. The nickel-containing film thus obtained showed a uniform gloss. Next, copper plating was carried out using a commercially available copper sulfate plating bath to form a copper plating film with a thickness of 25 μm. The film was washed with water. A treatment using Entech Cu-56 (Meltex Co.) was carried out at room temperature for 20 seconds to prevent oxidation of the copper film, followed by washing with water and drying. After an annealing treatment at 120°C for 1 hour, the peel strength of the copper film was measured. As a result, the peel strength was found to be 11 N/cm, suggesting tight attachment of the film onto the resin surface.

Practical Example 5

Preparation of a built-up base board

As an insulating layer, an epoxy resin (Matsushita Denko Co.) was coated (100 μm) on a base board with a size of 5 cm x 10 cm (thickness 1.6 mm, compressed epoxy resin containing 8 layers of glass fiber crossing nets as the reinforcing material) and then hardened at 150°C for 1 hour. Micro-vias were formed using a carbon dioxide laser. The base board was treated with a desmear treatment {sic!} to generate a rough surface and then treated on a normal pressure plasma device at 80 kV using a distance of 2 cm between the electrodes. The base board was dipped into an aqueous solution containing 0.05 mol/L of copper sulfate at room temperature for 5 minutes and washed with water. The base board was further dipped into an aqueous solution containing 0.02 mol/L of sodium borohydride at room temperature for 20 minutes and washed with water and dried. The copper-containing base board thus obtained showed a uniform gloss. Next, copper plating was carried out using a commercially available copper sulfate plating bath to form a copper plating film with a thickness of 25 μm. The film was washed with water. A treatment using Entech Cu-56 (Meltex Co.) was carried out at room temperature for 20 seconds to prevent oxidation of the copper film, followed by washing with water and drying. After an annealing treatment at 120°C for 1 hour, the peel strength of the copper film was measured. As a result, the peel strength was found to be 12 N/cm, suggesting tight attachment of the film onto the resin surface.

Practical Example 6

Preparation of an iron oxide magnetic film

The epoxy resin film treated with the plasma treatment in Practical Example 2 was dipped into an aqueous solution containing 0.05 mol/L of iron(II) sulfate at room temperature for 3 minutes (maintaining pH 3). The iron ions were attached chemically to the carboxyl groups formed on the surface of the resin base. The resin film was then washed with water at room temperature for 1 minute. Next, the resin film was dipped into an aqueous solution containing 1 mol/L of sodium hydroxide at 50°C for 3 minutes to form an iron oxide layer, which was further heated at 150°C for 30 minutes to form $Fe_3O_4$. The film thus obtained was evaluated on a V. S. MAGNETOMETER (RIKENDENSHI CO., LTD). As a result, a hysteresis loop of 0.025 emu in the vertical axis and 5 kOe in the horizontal axis was obtained, showing that the iron oxide magnetic film prepared above had the same magnetic properties as those of a commonly used magnetic tape.

Practical Example 7

Preparation of a ZnSe compound semiconductor film

The epoxy resin film treated with the plasma treatment in Practical Example 2 was dipped into an aqueous solution containing 0.05 mol/L of zinc nitrate at room temperature for 3 minutes (maintaining pH 3). The zinc ions were attached chemically to the carboxyl groups formed on the surface of the resin base. The resin film was then washed with water at room temperature for 1 minute. Next, the resin film was dipped into an aqueous solution containing 0.5 mol/L of selenourea and 0.5 mol/L of hydrazine at 60°C for 3 minutes to form a zinc and selenium layer.

The film was further washed with water at room temperature for 1 minute to clean the surface and then heated at 100°C for 5 minutes in a nitrogen atmosphere using a dryer. The film thus obtained had the same semiconductor properties as those of a ZnSe film prepared with the current dry method.
Moreover, the expression of "same semiconductor properties" means that the conductivity of the film obtained above was in the range of $10^{-2}$ - $10^9$ Ω/cm and the surface resistance value was in the range of 2 x $10^{-3}$ - 2 x $10^9$ Ω/

In this invention, the surface resistance value in Ω/ was determined with the following method. First, a conducting paint was coated on the testing specimen with width = 1 mm and length = 5 mm. Resistance value R of the part not coated with the conducting paint (length = 5 mm) was measured. The surface resistance value was then calculated with the following equation.

$$\text{Surface electric resistance value } (\Omega/\ ) = R\ (\Omega)\ x\ \text{width (mm)/length (mm)}$$

In the following practical examples, the surface resistance value was determined with the same method.

Practical Example 8

Preparation of a CdSe compound semiconductor film

The epoxy resin film treated with the plasma treatment in Practical Example 2 was dipped into an aqueous solution containing 0.05 mol/L of cadmium nitrate at room temperature for 3 minutes (maintaining pH 3). The cadmium ions were attached chemically to the carboxyl groups formed on the surface of the resin base. The resin film was then washed with water at room temperature for 1 minute. Next, the resin film was dipped into an aqueous solution containing 0.5 mol/L of selenourea and 0.5 mol/L of hydrazine at 60°C for 3 minutes to form a cadmium - selenium layer. The film was further washed with water at room temperature for 1 minute to clean the surface and then heated at 100°C for 5 minutes in a nitrogen atmosphere using a dryer. The film thus obtained had the same semiconductor properties as those of a CdSe film prepared with the current dry method.

Practical Example 9

Preparation of a CdTe compound semiconductor film

The epoxy resin film treated with the plasma treatment in Practical Example 2 was dipped into an aqueous solution containing 0.05 mol/L of cadmium nitrate at room temperature for 3 minutes (maintaining pH 3). The cadmium ions were attached chemically to the carboxyl groups formed on the surface of the resin base. The resin film was then washed with water at room temperature for 1 minute. Next, the resin film was dipped into an aqueous solution containing 0.5 mol/L of tellurium chloride and 0.5 mol/L of hydrazine at 60°C for 3 minutes to form a cadmium-tellurium layer. The film was further washed with water at room temperature for 1 minute to clean the surface and then heated at 100°C for 5 minutes in a nitrogen atmosphere using a dryer. The film thus obtained had the same semiconductor properties as those of a CdTe film prepared with the current dry method.

Practical Example 10

Preparation of a CdS compound semiconductor film

The epoxy resin film treated with the plasma treatment in Practical Example 2 was dipped into an aqueous solution containing 0.05 mol/L of cadmium nitrate at room temperature for 3 minutes (maintaining pH 3). The cadmium ions were attached chemically to the carboxyl groups formed on the surface of the resin base. The resin film was then washed with water at room temperature for 1 minute. Next, the resin film was dipped into an aqueous solution containing 0.25 mol/L of sodium sulfide at room temperature for 3 minutes to form a cadmium sulfide layer. The film was further washed with water at room temperature for 1 minute to clean the surface and then dried in air at room temperature. The film thus obtained had the same semiconductor properties as those of a CdS film prepared with the current dry method.

Practical Example 11

Preparation of a ZnS compound semiconductor film

The epoxy resin film treated with the plasma treatment in Practical Example 2 was dipped into an aqueous solution containing 0.05 mol/L of zinc nitrate at room temperature for 3 minutes (maintaining pH 3). The zinc ions were attached chemically to the carboxyl groups formed on the surface of the resin base. The resin film was then washed with water at room temperature for 1 minute. Next, the resin film was dipped into an aqueous solution containing 0.25 mol/L of sodium sulfide at room temperature for 3 minutes to form a cadmium sulfide layer. The film was further washed with water at room temperature for 1 minute to clean the surface and then dried in air at room temperature. The film thus obtained had the same semiconductor properties as those of a ZnS film prepared with the current dry method.

Practical Example 12

Preparation of an InAs compound semiconductor film

The epoxy resin film treated with the plasma treatment in Practical Example 2 was dipped into an aqueous solution containing 0.05 mol/L of indium sulfate at room temperature for 3 minutes (maintaining pH 3). The indium ions were attached chemically to the carboxyl groups formed on the surface of the resin base. The resin film was then washed with water at room temperature for 1 minute. Next, the resin film was dipped into an aqueous solution containing 0.5 mol/L of arsenous acid and 0.5 mol/L of hydrazine at 60°C for 3 minutes to form an indium-arsenic layer. The film was further washed with water at room temperature for 1 minute to clean the surface and then heated at 100°C for 5 minutes in a nitrogen atmosphere using a dryer. The film thus obtained had the same semiconductor properties as those of an InAs film prepared with the current dry method.

Practical Example 13

Preparation of an InSb compound semiconductor film

The epoxy resin film treated with the plasma treatment in Practical Example 2 was dipped into an aqueous solution containing 0.05 mol/L of indium sulfate at room temperature for 3 minutes (maintaining pH 3). The indium ions were attached chemically to the carboxyl groups formed on the surface of the resin base. The resin film was then washed with water at room temperature for 1 minute. Next, the resin film was dipped into an aqueous solution containing 0.5 mol/L of antimony trichloride and 0.5 mol/L of hydrazine at 60°C for 3 minutes to form an indium-antimony layer. The film was further washed with water at room temperature for 1 minute to clean the surface and then heated at 100°C for 5 minutes in a nitrogen atmosphere using a dryer. The film thus obtained had the same semiconductor properties as those of an InSb film prepared with the current dry method.

Comparative Example 1

Formation of a copper thin film on a polyimide resin

A polyimide resin film (Capton Film 200-H, Torei-Du Pont Co.) with a size of 5 cm x 10 cm was first treated with electroless copper plating using a common procedure to form a copper film. Then, copper plating was carried out using a commercially available copper sulfate plating bath to form a copper plating film with a thickness of 25 μm. The

film was washed with water. A treatment using Entech Cu-56 (Meltex Co.) was carried out at room temperature for 20 seconds to prevent oxidation of the copper film, followed by washing with water and drying. After an annealing treatment at 120°C for 1 hour, the peel strength of the copper film was measured. As a result, the peel strength was found to be 2 N/cm, suggesting poor attachment of the film onto the resin surface.

Practical Example 14

An epoxy resin base was first dipped into an aqueous solution containing 1 M KOH at 25°C for 2 minutes to clean the surface and washed with water and dried. Then, the resin surface was treated with oxygen plasma (60 kW) at 25°C and 1 atmosphere for 10 seconds to form carboxyl groups on the resin surface as cation-exchanger group. The resin base was dipped into an aqueous solution containing 0.1 M of $CuSO_4$ at 25°C for 5 minutes and washed with water and dried. The resin surface was irradiated with ultraviolet light generated from a 140-W low-pressure mercury lamp for 1 hour to reduce copper ions to copper. The reduction-treated resin surface thus obtained showed a metallic gloss. Next, copper plating was carried out at 2 A/dm$^2$ for 60 minutes to form a copper plating film with a thickness of about 25 μm. The resin surface was washed with water and dried. The resin base was cut with a knife into strips with a width of 1 cm and the peel strength of the copper film was measured. As a result, the peel strength was found to be 9.8 N/cm, suggesting tight attachment of the film onto the resin surface.

Practical Example 15

A polyimide resin base was first dipped into an aqueous solution containing 1 M KOH at 25°C for 2 minutes to clean the surface and washed with water and dried. Then, the resin surface was treated with oxygen plasma (60 kW) at 25°C and 1 atmosphere for 10 seconds to form carboxyl groups on the resin surface as cation-exchanger groups. The resin base was dipped into an aqueous solution containing 0.1 M of $AgNO_3$ at 25°C for 3 minutes and washed with water and dried. The resin surface was irradiated through a quartz glass mask pattern with ultraviolet light, generated from a 140-W low-pressure mercury lamp for 1 hour, to form a silver circuit. The metal ions remaining on the parts other than the circuit were removed by dissolution in a 1% nitric acid solution. The resin surface was washed with water and dried. Next, the tape peel test was carried out. As a result, no peeling by the tape was observed, suggesting tight attachment of the film onto the resin surface.

Practical Example 16

An ABS resin base was treated with oxygen plasma (30 kW) at 25°C and 1 atmosphere for 5 seconds to form carboxyl groups on the resin surface as cation-exchanger groups. The resin base was then dipped into an aqueous solution containing 0.1 M of $NiSO_4$ at 25°C for 3 minutes and was washed with water and dried. The resin surface was irradiated with ultraviolet light (500 W) at 25°C and 1 atmosphere for 5 minutes. The ABS resin surface treated with ultraviolet light showed a nickel pattern with a metallic gloss. Next, the tape peel test was carried out. As a result, no peeling by the tape was observed, suggesting tight attachment of the film onto the resin surface.

Practical Example 17

A polyimide resin base was treated with plasma (400 W) in an ammonia gas atmosphere at 25°C under 8 Torr for 60 seconds to form amino groups on the resin surface as cation-exchanger groups. Then, the resin base was dipped into an aqueous solution containing 0.05 M of $CuSO_4$ at 25°C for 5 minutes and washed with water and dried. The resin surface was irradiated with ultraviolet light generated from a 500-W high-pressure mercury lamp for 10 minutes to reduce the copper ions to copper. The reduction-treated resin surface thus obtained showed a metallic gloss. Next, copper plating was carried out at 2 A/dm$^2$ for 60 minutes to form a copper plating film with a thickness of about 25 μm. The resin surface was washed with water and dried. The resin base was cut with a knife into strips with a width of 1 cm and the peel strength of the copper film was measured. As a result, the peel strength was found to be 9.8 N/cm, suggesting tight attachment of the film onto the resin surface.

Practical Example 18

A polyimide resin base was treated with plasma (400 W) in a nitrogen atmosphere at 25°C under 8 Torr for 5 minutes to form nitro groups on the resin surface as cation-exchanger groups. Then, the resin base was dipped into an aqueous solution containing 0.1 M of $CuSO_4$ at 25°C for 5 minutes and washed with water and dried. The resin surface was irradiated with ultraviolet light generated from a 500-W high-pressure mercury lamp for 10 minutes to reduce the copper ions to copper. The reduction-treated resin surface thus obtained showed a metallic gloss. Next, copper plating was carried out at 2 A/dm$^2$ for 60 minutes to form a copper plating film with a thickness of about 25 $\mu$m. The resin surface was washed with water and dried. The resin base was cut with a knife into strips with a width of 1 cm and the peel strength of the copper film was measured. As a result, the peel strength was found to be 9.8 N/cm, suggesting tight attachment of the film onto the resin surface.

Practical Example 19

Preparation of a not electrically chargeable resin composite material

An ABS resin base was treated with oxygen plasma (30 kW) at 25°C and 1 atmosphere for 10 seconds to form carboxyl groups on the resin surface as cation-exchanger groups. Then, the resin base was dipped into an aqueous solution containing 0.1 M of nickel sulfate at 25°C for 3 minutes and washed with water. Next, the resin base was dipped into an aqueous solution containing 0.01 M of hypophosphorous acid for 20 minutes to reduce the nickel ions to nickel. The resin base thus treated had a surface resistance value of 1 x 10$^9$ $\Omega$/. The resistivity of nickel was 6.84 x 10$^{-6}$ $\Omega$·cm. Therefore, the resin composite material thus obtained had a ratio of the surface resistance value/metal-element-containing component resistivity = 1.5 x 10$^{14}$ (1/( -cm)) [sic].

Practical Example 20

Preparation of a not electrically chargeable resin composite material

An ABS resin base was treated with oxygen plasma (30 kW) at 25°C and 1 atmosphere for 5 seconds to form carboxyl groups on the resin surface as cation-exchanger groups. Then, the resin base was dipped into an aqueous solution containing 0.1 M of nickel sulfate at 25°C for 3 minutes and washed with water and dried. Next, the resin surface was irradiated with ultraviolet light generated from a 500 W high-pressure mercury lamp at 25°C and 1 atmosphere for 5 minutes to reduce the nickel ions to nickel. The resin base thus treated had a surface resistance value of 1 x 10$^{10}$ $\Omega$/. The resistivity of nickel was 6.84 x 10$^{-6}$ $\Omega$-cm. Therefore, the resin composite material thus obtained had a ratio of the surface resistance value/metal-element-containing component resistivity = 1.5 x 10$^{14}$ (1/(-cm)) [sic].

Practical Example 21

Preparation of a not electrically chargeable resin composite material

A polyimide resin base was first dipped into an aqueous solution containing 1 M of potassium hydroxide at 25°C for 4 minutes and washed with water and dried. The resin base was further treated in an oxygen plasma (40 kW) at 25°C and 1 atmosphere for 5 seconds to form carboxyl groups on the resin surface as cation-exchanger groups. Then, the resin base was dipped into an aqueous solution containing 0.1 M of NiSO$_4$ at 25°C for 5 minutes and washed with water.
Next, the resin base was dipped into an aqueous solution containing 0.01 M of hypophosphorous acid for 20 minutes to reduce the nickel ions to nickel. The resin base thus treated had a surface resistance value of 5 x 10$^9$ $\Omega$/. The resistivity of nickel was 6.84 x 10$^{-6}$ $\Omega$-cm. Therefore, the resin composite material thus obtained had a ratio of the surface resistance value/metal-element-containing component resistivity = 7.3 x 10$^{14}$ (1/( -cm)).

Practical Example 22

Preparation of a not electrically chargeable resin composite material

A polyimide resin base was treated with oxygen plasma (30 kW) at 25°C and 1 atmosphere for 5 seconds to form carboxyl groups on the resin surface as cation-exchanger groups. Then, the resin base was washed with water and dipped into an aqueous solution containing 0.1 M of cobalt sulfate at 25°C for 5 minutes and washed with water and dried. Next, the resin surface was irradiated with ultraviolet light generated by a 140-W low-pressure mercury lamp for 1 hour to reduce the cobalt ions to cobalt. The resin base thus treated had a surface resistance value of 1 x 10$^{10}$ $\Omega$/. The resistivity of nickel was 6.24 x 10$^{-5}$ $\Omega$-cm. Therefore, the resin composite material thus obtained had a ratio of the surface resistance value/metal-element-containing component resistivity = 1.6 x 10$^{15}$ (1/( -cm)).

As clearly shown by the results obtained from Practical Examples 19 - 22, the resin composite material prepared through a process, which consists of a plasma treatment of a resin base, a dipping treatment of the resin base into an aqueous solution containing metal ions, and a conversion treatment, has a surface resistance value in a suitable range and is not electrically chargeable.

Potential utilization in industry

As described above, the resin composite material of this invention carries a metal-element-containing component layer on the surface of a resin base with excellent distribution of the metal-element-containing component in the surface layer and a uniform thickness of the surface layer and is very useful for purposes requiring excellent distribution of the metal-element-containing component in the surface layer and a uniform thickness of the surface layer. In addition, the resin composite material of this invention carries a metal-element-containing component layer tightly attached to the surface of a resin base and is very useful for purposes requiring tight attachment of the surface layer on the resin base. The resin composite material of this invention is formed with a wet method through a simple process, which does not require the large and special equipment used in the current dry method.

Moreover, the resin composite material of this invention is formed through a simple process without using etching treatment and electroless plating. Therefore, the process will not cause environmental pollution and is not harmful to working conditions. In other words, the method of this invention is able to form a surface layer, which may contain various metal-element-containing components, with a uniform thickness and tight attachment onto the surface of the resin base through a relatively simple and potentially continuous process, consisting of a plasma treatment and wet treatment. In the method of this invention, since the reductive conversion of the metal ion to metal can be carried out under electromagnetic irradiation, a metal layer with a certain pattern can be formed easily on the surface of a resin base.

Furthermore, by using the method of this invention, it is possible to introduce a very trace amount of a metal-element-containing component onto the surface of a resin base, which is sufficient for preventing the resin base from carrying static charges, while maintaining the low conductivity of the resin base at a certain level. In fact, this is very difficult to achieve using the current method. Therefore, the not electrically chargeable resin composite material of this invention will not be damaged by static charges and will not have the problem caused by attachment of dust and small particles due to static charges. In addition, since the metal-element-containing component layer on the surface of the resin base has tight attachment on the resin surface, the effect of being not electrically chargeable of the resin composite material of this invention is permanent.

**Claims**

1. A resin composite material, which carries a metal-element-containing component on the surface of a resin base and is prepared through a wet treatment, **characterized by** containing no catalyst layer.

2. A resin composite material, which carries a metal-element-containing component on the surface of a resin base and is prepared through a process using a metal-ion-containing liquid agent to treat a plasma-pretreated surface of the resin base to introduce metal ions, followed by a conversion step of the metal ions.

3. The resin composite material described in Claim (1) or Claim (2), **characterized by** that the metal-element-containing component forms a metal-element-containing film on the resin base.

4. The resin composite material described in any one item of Claims (1) - (3), **characterized by** that the metal-element-containing component is selected from metals, metal arsenides, metal antimonides, metal selenides, metal tellurides, metal sulfides, and metal oxides.

5. The resin composite material described in any one item of Claims (1) - (4), **characterized by** having improved attachment of the metal-element-containing component on the resin base.

6. The resin composite material described in Claim (5), **characterized by** that the metal-element-containing film is a metal film and has a film-peel strength of 3 N/cm or higher.

7. The resin composite material described in Claim (5), **characterized by** that the metal-element-containing film is a metal arsenide film, a metal antimonide film, a metal selenide film, a metal telluride film, a metal sulfide film, or a metal oxide film and shows no film peeling in the tape peel test.

8. The resin composite material described in any one item of Claims (1) - (5), **characterized by** that the resin composite material is not electrically chargeable.

9. The resin composite material described in Claim (8), **characterized by** that the resin composite material has a surface resistance value in the range of $10^6$ - $10^{11}$ $\Omega/$.

10. The resin composite material described in Claim (8) or Claim (9), **characterized by** that the resin composite material has a ratio of the surface resistance value/metal-element-containing component resistivity in the range of $10^{12}$ - $10^{17}$ (1/( -cm).

11. The resin composite material described in any one of Claims (1) - (10), **characterized by** that the metal element is selected from V, Cr, Mn, Fe, Co, Ni, Cu, Ga, As, Se, Mo, Ru, Rh, Pd, Ag, Cd, In, Sb, Te, Os, Ir, Pt, Au, Hg, Pb, and Bi as well as a mixture of these metals.

12. The resin composite material described in any one of Claims (1) - (3), **characterized by** that the metal-element-containing component is a metal and the conversion step is carried out under electromagnetic irradiation.

13. The resin composite material described in Claim (12), **characterized by** that the electromagnetic irradiation is carried out through a mask pattern to form a metal film with a pattern.

14. A method for forming the resin composite material described in Claim (1) or Claim (2), **characterized by** consisting of (1) treatment of the resin base with plasma, (2) treatment with a metal-ion-containing liquid agent, and (3) conversion to introduce the metal-element-containing component to the resin surface.

15. The method described in Claim (14), **characterized by** that the metal-element-containing component is introduced to form a film.

## INTERNATIONAL SEARCH REPORT

| International application No. |
| --- |
| PCT/JP01/10645 |

**A. CLASSIFICATION OF SUBJECT MATTER**
Int.Cl⁷ $C08J7/06, 7/00$

According to International Patent Classification (IPC) or to both national classification and IPC

**B. FIELDS SEARCHED**

Minimum documentation searched (classification system followed by classification symbols)
Int.Cl⁷ $C08J7/00-7/18, B32B27/00-27/42$

Documentation searched other than minimum documentation to the extent that such documents are included in the fields searched
Jitsuyo Shinan Koho    1926–1996    Toroku Jitsuyo Shinan Koho   1994–2002
Kokai Jitsuyo Shinan Koho   1971–2002    Jitsuyo Shinan Toroku Koho   1996–2002

Electronic data base consulted during the international search (name of data base and, where practicable, search terms used)
WPI/L

**C. DOCUMENTS CONSIDERED TO BE RELEVANT**

| Category* | Citation of document, with indication, where appropriate, of the relevant passages | Relevant to claim No. |
| --- | --- | --- |
| PX | JP, 2001-73159, A (Nippon Rironaru K.K.), 21 March, 2001 (21.03.01), Claims (Family: none) | 1,3-5,7,8, 11-13 |
| X | JP, 10-245444, A (Nippon Rironaru K.K.), 14 September, 1998 (14.09.98), Claims (Family: none) | 1,3-11 |
| Y | | 2,12,14,15 |
| X | JP, 8-209354, A (Nippon Rironaru K.K.), 13 August, 1996 (13.08.96), Claims (Family: none) | 1,3-11 |
| Y | | 2,12,14,15 |
| X | JP, 64-87639, A (The Furukawa Electric Co., Ltd.), 31 March, 1989 (31.03.89), Claims (Family: none) | 1,3-11 |
| Y | | 2,12,14,15 |
| X | JP, 61-39311, A (Asahi Chemical Industry Co., Ltd.), 25 February, 1986 (25.02.86), Claims (Family: none) | 1,3-11 |
| Y | | 2,12,14,15 |

[X] Further documents are listed in the continuation of Box C.    [ ] See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 04 March, 2002 (04.03.02) | 19 March, 2002 (19.03.02) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

## EP 1 364 984 A1

### INTERNATIONAL SEARCH REPORT

| International application No. |
| --- |
| PCT/JP01/10645 |

**C (Continuation). DOCUMENTS CONSIDERED TO BE RELEVANT**

| Category* | Citation of document, with indication, where appropriate, of the relevant passages | Relevant to claim No. |
| --- | --- | --- |
| X<br>Y | JP, 57-40501, A (Toyobo Co., Ltd.),<br>06 March, 1982 (06.03.82),<br>Claims (Family: none) | 1,3-11<br>2,12,14,15 |
| Y | JP, 4-126873, A (Kureha Chemical Industry Co., Ltd.),<br>27 April, 1992 (27.04.92),<br>Claims (Family: none) | 2,14,15 |
| Y | JP, 58-77030, A (Hitachi Maxell, Ltd.),<br>10 May, 1983 (10.05.83),<br>Claims (Family: none) | 2,14,15 |
| Y | JP, 2000-154266, A (Polyplastics Co., Ltd.),<br>06 June, 2000 (06.06.00),<br>Claims; Par. Nos. [0009]<br>(Family: none) | 12 |
| A | JP, 1-230784, A (Nisshinbo Industries, Inc.),<br>14 September, 1989 (14.09.89),<br>Claims<br>& EP 319263 B        & US 5183611 A<br>& DE 3887969 T2 | 1-15 |

Form PCT/ISA/210 (continuation of second sheet) (July 1998)

20